# EUROPEAN PATENT APPLICATION

(11) **EP 4 513 589 A1**
(43) Date of publication of application: **26.02.2025**
(21) Application number: 22941908.0
(22) Date of filing: 16.05.2022
(51) Int. Cl.: H01M 4/36

(54) **SECONDARY BATTERY AND BATTERY MODULE COMPRISING SAME, BATTERY PACK, AND ELECTRICAL DEVICE**

(71) Applicant: Contemporary Amperex Technology (Hong Kong) Limited, Hong Kong (HK)
(72) Inventor: PENG, Chang, Ningde City, Fujian 352100 (CN); CHEN, Peipei, Ningde City, Fujian 352100 (CN); ZHANG, Zhenguo, Ningde City, Fujian 352100 (CN)
(74) Representative: Jacob, Reuben Ellis
(86) International application number: PCT/CN2022/092999
(87) International publication number: WO 2023/220856

(57) **Abstract**

Provided is a secondary battery (5), comprising a positive electrode sheet, a negative electrode sheet, a separator, and an electrolyte. The positive electrode sheet comprises a positive electrode active material; the positive electrode active material comprises a core and a coating; the content of manganese in the core is greater than or equal to 25% on the basis of the weight of the core; the coating covers the surface of the core, and contains one or more of an oxide, a hydroxide, and an oxysalt of an element X; the element X is selected from one or more of Al, B, or P; the weight ratio of the coating to the core is 1:5-100, optionally 1:16-100; the electrolyte contains a first solvent; and the first solvent is selected from one or more of fluorocarbonate, fluorocarboxylate, fluorosulfone, fluoroether, or fluorobenzene. The secondary battery has good electric storage performance and cycle performance. Further provided are a related battery module, a battery pack, and an electrical device.

## Description

### TECHNICAL FIELD

This application relates to the technical field of lithium batteries, and in particular, to a secondary battery and a battery module containing same, a battery pack, and an electrical device.

### BACKGROUND

In recent years, with lithium-ion batteries being applied more widely, people have put forward more requirements on the performance of secondary batteries. One of the requirements is high storage performance and cycle performance of the secondary batteries, especially under high-voltage conditions. Therefore, how to provide a secondary battery of high storage performance and cycle performance under high-voltage conditions is still a technical challenge to a person skilled in the art.

### SUMMARY

This application is developed to meet the above challenge. An objective of this application is to provide a secondary battery. The secondary battery is of significantly improved storage performance and cycle performance under high-voltage conditions.

A first aspect of this application provides a secondary battery. The secondary battery includes a positive electrode plate, a negative electrode plate, a separator, and an electrolyte solution.

The positive electrode plate includes a positive active material. The positive active material includes a core and a coating. A manganese content of the core is greater than or equal to 25% based on a mass of the core. The coating overlays a surface of the core and contains one or more of an oxide, hydroxide, or oxyacid salt of element X. The element X is one or more selected from Al, B, or P. A mass ratio of the coating to the core is 1: (5 to 100), and optionally 1: (16 to 100).

The electrolyte solution contains a first solvent. The first solvent is one or more selected from a fluorocarbonate ester, a fluorocarboxylate ester, a fluorosulfone, a fluoroether, or a fluorobenzene.

When the positive active material and the electrolyte solution of the secondary battery disclosed in this application satisfy the above conditions, the secondary battery is of high stability, thereby improving the storage performance and cycle performance of the secondary battery.

In any embodiment, optionally, a manganese ion dissolution coefficient of the positive electrode plate, denoted as k, satisfies: k ≤ 0.035%, optionally k ≤ 0.017%, and further optionally k ≤ 0.01%, where the manganese ion dissolution coefficient is a mass percent of manganese ions in the electrolyte solution after the positive electrode plate in a fully charged state is stored together with the electrolyte solution at 60 °C for 48 hours, and an injection coefficient of the electrolyte solution is 5 g/Ah).

When the manganese ion dissolution coefficient of the positive electrode plate satisfies the above conditions, this application can significantly improve the stability of the cathode electrolyte interface, reduce side reactions on the interface, improve the stability of the secondary battery, and in turn, improve the storage performance and cycle performance of the secondary battery.

In any embodiment, optionally, a static protection layer stability coefficient of the positive electrode plate is 54% ≤ e1 ≤ 100%, optionally 70% ≤ e1 ≤ 100%, and further optionally 85% ≤ e1 ≤ 100%, where the static protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer when the positive electrode plate is in a fully charged initial state.

When the protection layer stability coefficient of the positive electrode plate satisfies the above conditions, this application can further improve the stability of the secondary battery, and improve the storage performance and cycle performance of the secondary battery.

In any embodiment, optionally, a dynamic protection layer stability coefficient e2 of the positive electrode plate satisfies: 20% ≤ e2 ≤ 100%, optionally 50% ≤ e2 ≤ 100%, and further optionally 70% ≤ e2 ≤ 100%, where the dynamic protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer before the storage.

When the dynamic protection layer stability coefficient e2 falls within the above range, the secondary battery is of relatively high stability, thereby improving the storage performance and cycle performance of the secondary battery.

In any embodiment, optionally, a mass percent of the element X in a positive electrode film layer is 0.05% to 5.35%, optionally 0.1% to 1.61%, and further optionally 0.24% to 1.61%, based on a total mass of the positive active material.

When the mass percent of the element X in the positive electrode film layer falls within the above range, this application can effectively reduce the direct contact between the core material and the electrolyte solution, reduce side reactions, reduce the dissolution of manganese ions, and in turn, improve the storage performance and cycle performance of the secondary battery.

In any embodiment, optionally, the core is one or more selected from LiMₚMn₂₋ₚO₄, LiN_{g}Mn_{1-q}PO₄, or Li₁₊tMn_{1-w}L_{w}O₂₊ₜ, where 0 ≤ p ≤ 1, 0 ≤ q ≤ 0.5, 0 ≤ t ≤ 1, 0 ≤ w ≤ 0.5; and M, N, and L each independently represent one or more of Ni, Co, Fe, Cr, V, Ti, Zr, La, Ce, Rb, P, W, Nb, Mo, Sb, B, Al, or Si.

Further optionally, the core is one or more of LiMₚMn₂₋ₚO₄ or Li₁₊tMn_{1-w}L_{w}O₂₊ₜ.

Further optionally, the core is one or more of LiNi_{0.5}Mn_{1.5}O₄, LiNi_{0.5}Co_{0.2}Mn_{0.3}O₂, Li₂MnO₃, or LiMnPO₄.

When the core material of the secondary battery is selected from the above types of materials, this application increases the energy density of the secondary battery, reduces the manufacturing cost, and gives rise to little environmental pollution.

In any embodiment, optionally, the coating is one or more selected from aluminum oxide, boron oxide, a borate salt represented by A^{a+}ₓ[BO₃]³⁻_{y}, a phosphate salt represented by A^{a+}ₓ[PO₄]³⁻_{y}, or a aluminate salt represented by A^{a+}ₓ[AlO₂]¹⁻_{z}, in which A represents one or more of Li, Na, K, Rb, Cs, Mg, Ca, Ba, Ni, Fe, Co, Ti, Al, Cr, V, Nb, or W, each compound is electrically neutral, and a, x, y, or z is selected from 1, 2, or 3.

Optionally, the coating is one or more of Al₂O₃, B₂O₃, Li₃BO₃, Li₃PO₄, Na₃PO₄, or LiAlO₂.

When the coating is selected from the above substances, this application reduces the dissolution of transition metals, reduces side reactions on the interface, and in turn, improves battery performance.

In any embodiment, optionally, the first solvent is one or more selected from 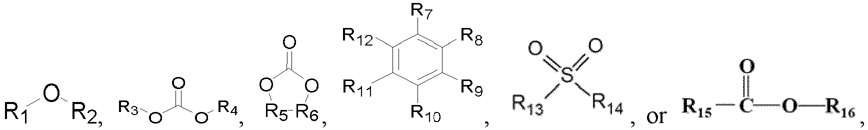 where R₁, R₃, R₅, and R₁₃ each are independently selected from C₁ to C₆ fluoroalkanes; R₂, R₄, R₆, R₁₄, R₁₅, and R₁₆ each are independently selected from C₁ to C₆ alkanes or C₁ to C₆ fluoroalkanes; R₇ to R₁₂ each are independently selected from a C₁ to C₆ fluoroalkane, fluorine, or hydrogen; at least one of R₇ to R₁₂ is selected from fluorine or a fluoroalkane; and at least one of R₁₅ or R₁₆ is selected from C₁ to C₆ fluoroalkanes.

Optionally, the first solvent is one or more of 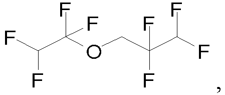 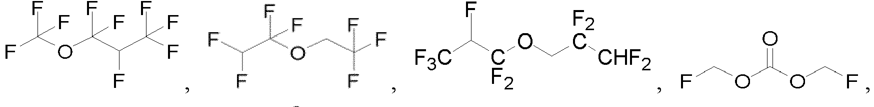 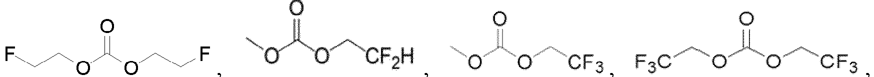 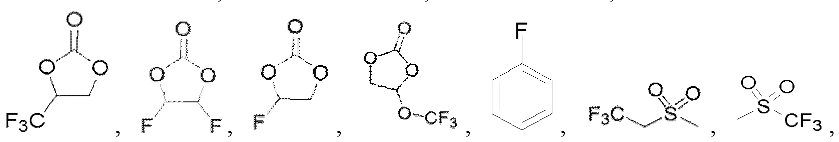 or

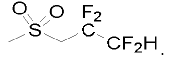

In any embodiment, optionally, the electrolyte solution further includes a second solvent. The second solvent is one or more selected from a non-fluorinated carbonate ester, a non-fluorinated carboxylate ester, a non-fluorinated ether, or a non-fluorinated sulfone.

Optionally, the second solvent is one or more of 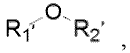 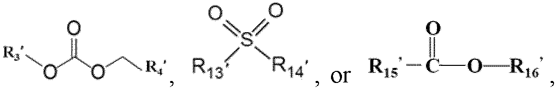 where R₁', R₂', R₃', R₁₃', R₁₄', and R₁₆' each are independently selected from C₁ to C₆ alkanes; and R₄' and R₁₅' each are independently selected from a C₁ to C₆ alkane or hydrogen.

Optionally, the second solvent is one or more of ethyl methyl carbonate, dimethyl carbonate, diethyl carbonate, ethylene carbonate, propylene carbonate, methyl formate, methyl acetate, ethyl acetate, propyl acetate, methyl propionate, ethyl propionate, or propyl propionate.

When the first solvent and the second solvent are selected from the above solvents, the solvent can combine with a lithium salt in the electrolyte solution to form a special solvation structure, thereby reducing side reactions of the solvent on the surfaces of the positive and negative electrodes and increasing the lifespan of the secondary battery.

In any embodiment, optionally, a mass percent y₁ of the first solvent is 10% to 100%, optionally 40% to 100%, and further optionally 80% to 100%, based on a total mass of the first solvent and the second solvent.

In any embodiment, optionally, a mass percent y₂ of the second solvent is 0% to 90%, optionally 0% to 60%, and further optionally 0% to 20%, based on a total mass of the first solvent and the second solvent.

In any embodiment, optionally, the mass percent y₁ of the first solvent and a mass percent y₂ of the second solvent satisfy: y₁/y₂ ≥ 0.66, optionally y₁/y₂ ≥ 2.33, and further optionally y₁/y₂ ≥ 4.

When the mass percent of the first solvent and the mass percent of the second solvent fall within the above ranges, this application further improves the storage performance and cycle performance of the secondary battery.

In any embodiment, optionally, the electrolyte solution further includes a film-forming additive. The film-forming additive is one or more selected from a chain or cyclic sulfate ester, a chain or cyclic sulfonate ester, a chain or cyclic carbonate ester, a polycyclic sulfate ester, or a polycyclic sulfonate ester.

Optionally, the film-forming additive is one or more of 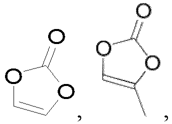 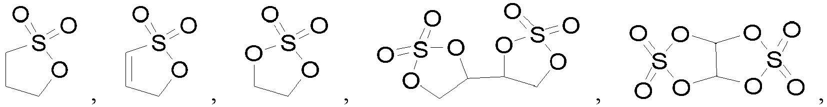 or

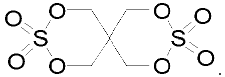

Further optionally, the film-forming additive is one or more of

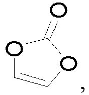

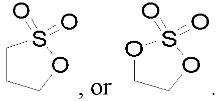

The film-forming additive can form a film on the negative electrode preferentially, thereby reducing the loss of active lithium, and in turn, improving battery performance.

In any embodiment, a mass percent of the film-forming additive is 0.5% to 20%, optionally 1% to 10%, and further optionally 1% to 5%, based on a total mass of the first solvent and the second solvent.

In any embodiment, optionally, the film-forming additive includes 0.5% to 3% 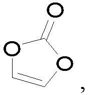 0.5% to 3% 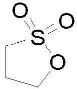 , and 0.5% to 3% 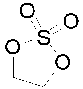 or 0.5% to 3% 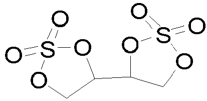 , based on a total mass of the first solvent and the second solvent.

When the electrolyte solution includes the film-forming additive added at the specified mass percent, this application further improves the storage performance and cycle performance of the secondary battery.

In any embodiment, optionally, the core further includes a doping element. The doping element is one or more selected from W, Nb, Sb, Ti, Zr, La, Ce, or S, and optionally one or more of W or Nb.

The element doping improves the electrochemical properties of the positive active material, thereby enhancing the electrochemical performance of the corresponding secondary battery.

In any embodiment, optionally, the mass percent of the doping element is 0.05% to 5%, and optionally 0.1% to 2%, based on the total mass of the core.

In any embodiment, optionally, particles of the positive active material are monocrystalline or quasi-monocrystalline.

When the positive active material is monocrystalline, the active material is not prone to fragmenting, thereby reducing the probability of exposing a new surface, and in turn, reducing side reactions of the electrolyte solution, and improving the stability of the electrolyte solution.

In any embodiment, optionally, a particle diameter of the positive active material is 1 to 20 µm, and optionally 3 to 15 µm.

When the particle diameter of the positive active material falls within the above range, this application avoids an increase in the energy consumption of the process and deterioration of the processing performance of the positive electrode plate due to an excessively large particle diameter.

In any embodiment, an acidity of the electrolyte solution is less than or equal to 50 ppm, and a purity of each solvent in use is greater than or equal to 99.9%.

When the acidity and purity of the electrolyte solution fall within the above ranges, the electrolyte solution is of high stability and is less prone to side reactions, thereby improving the cycle performance of the secondary battery.

A second aspect of this application provides a battery module. The battery module includes the secondary battery according to the first aspect of this application. The battery module may be prepared by a battery module preparation method commonly used in this field.

A third aspect of this application provides a battery pack. The battery pack includes the battery module according to the second aspect of this application. The battery pack may be prepared by the battery pack preparation method commonly used in this field.

A fourth aspect of this application provides an electrical device. The electrical device includes at least one of the secondary battery according to the first aspect of this application, the battery module according to the second aspect of this application, or the battery pack according to the third aspect of this application.

This application achieves at least the following beneficial effects:

In the secondary battery of this application, the positive active material includes a core and a coating that overlays the surface of the core. The mass ratio of the coating to the core is 1: (5 to 100). The appropriate mass ratio of the coating to the core is conducive to ensuring that the coating effectively reduces the direct contact between the core material and the electrolyte solution, thereby reducing side reactions on the interface and improving the storage performance and cycle performance of the secondary battery. On the other hand, this can also avoid an excessive amount of coating that leads to deterioration of the kinetic performance of the secondary battery. In addition, the coating itself is also a fast-ion conductor, and can avoid significantly reducing the overall capacity of the positive active material, thereby maintaining the high energy density of the secondary battery. In addition, the electrolyte solution in the secondary battery of this application contains the first solvent selected from fluorinated solvents, thereby improving the fluorination degree of the electrolyte solution, improving the compatibility between the electrolyte solution and the positive and negative electrodes, reducing the damage caused by the electrolyte solution to the positive and negative electrode materials, and in turn, improving the storage performance and cycle performance of the secondary battery.

The battery module, the battery pack, and the electrical device according to this application include the secondary battery according to this application, and therefore, have at least the same advantages as the secondary battery.

### BRIEF DESCRIPTION OF DRAWINGS

FIG. 1 is a schematic diagram of a secondary battery according to an embodiment of this application;
FIG. 2 is an exploded view of a secondary battery shown in FIG. 1 according to an embodiment of this application;
FIG. 3 is a schematic diagram of a battery module according to an embodiment of this application;
FIG. 4 is a schematic diagram of a battery pack according to an embodiment of this application;
FIG. 5 is an exploded view of a battery pack shown in FIG. 4 according to an embodiment of this application; and
FIG. 6 is a schematic diagram of an electrical device that uses a secondary battery as a power supply according to an embodiment of this application.

List of reference numerals:
1. battery pack; 2. upper box; 3. lower box; 4. battery module; 5. secondary battery; 51. housing; 52. electrode assembly; 53. cover plate.

### DETAILED DESCRIPTION OF EMBODIMENTS

The following describes and discloses in detail embodiments of a secondary battery, a battery module, a battery pack, and an electrical device according to this application with due reference to drawings. However, unnecessary details may be omitted in some cases. For example, a detailed description of a well-known matter or repeated description of an essentially identical structure may be omitted. That is intended to prevent the following descriptions from becoming unnecessarily lengthy, and to facilitate understanding by a person skilled in the art. In addition, the drawings and the following descriptions are intended for a person skilled in the art to thoroughly understand this application, but not intended to limit the subject-matter set forth in the claims.

A "range" disclosed herein is defined in the form of a lower limit and an upper limit. A given range is defined by a lower limit and an upper limit selected. The selected lower and upper limits define the boundaries of a particular range. A range so defined may be inclusive or exclusive of the end values, and a lower limit of one range may be arbitrarily combined with an upper limit of another range to form a range. For example, if a given parameter falls within a range of 60 to 120 and a range of 80 to 110, it is expectable that the parameter may fall within a range of 60 to 110 and a range of 80 to 120 as well. In addition, if lower-limit values 1 and 2 are listed, and if upper-limit values 3, 4, and 5 are listed, the following ranges are all expectable: 1 to 3, 1 to 4, 1 to 5, 2 to 3, 2 to 4, and 2 to 5. Unless otherwise specified herein, a numerical range "a to b" is a brief representation of a combination of any real numbers between a and b inclusive, where both a and b are real numbers. For example, a numerical range "0 to 5" herein means all real numbers recited between 0 and 5 inclusive, and the expression "0 to 5" is just a brief representation of a combination of such numbers. In addition, a statement that a parameter is an integer greater than or equal to 2 is equivalent to a disclosure that the parameter is an integer such as 2, 3, 4, 5, 6, 7, 8, 9, 10, 11, 12, and so on.

Unless otherwise expressly specified herein, any embodiments and optional embodiments hereof may be combined with each other to form a new technical solution.

Unless otherwise expressly specified herein, any technical features and optional technical features hereof may be combined with each other to form a new technical solution.

Unless otherwise expressly specified herein, all steps described herein may be performed in sequence or at random, and preferably in sequence. For example, that the method includes steps (a) and (b) indicates that the method may include steps (a) and (b) performed in sequence, or steps (b) and (a) performed in sequence. For example, that the method may further include step (c) indicates that step (c) may be added into the method in any order. For example, the method may include steps (a), (b), and (c), or may include steps (a), (c), and (b), or may include steps (c), (a), and (b), and so on.

Unless otherwise expressly specified herein, "include" and "comprise" mentioned herein mean open-ended inclusion, or closed-ended inclusion. For example, the terms "include" and "comprise" may mean inclusion of other items that are not recited, or inclusion of only the items recited.

Unless otherwise expressly specified, the term "or" used herein is inclusive. For example, the expression "A or B" means "A alone, B alone, or both A and B". More specifically, all and any of the following conditions satisfy the condition "A or B": A is true (or existent) and B is false (or absent); A is false (or absent) and B is true (or existent); and, both A and B are true (or existent).

It is hereby noted that, as used herein, the term "fully charged state" means a state of a secondary battery when the secondary battery is charged until an upper-limit cut-off voltage. Similarly, the term "fully charged initial state" means a state of a secondary battery when the secondary battery is prepared and charged until an upper-limit cut-off voltage in a case that the electrolyte solution contains no manganese.

It is hereby noted that, in this application, the term "protection layer stability coefficient" may be subdivided into "static protection layer stability coefficient" and "dynamic protection layer stability coefficient". The difference between the two is that the secondary battery used for measuring the static protection layer stability coefficient e1 is a freshly prepared secondary battery, but the secondary battery used for measuring the dynamic protection layer stability coefficient e2 may be either a freshly prepared secondary battery or a secondary battery that has been used for a period of time, without being limited.

The inventor hereof finds in practical operations that, when the secondary battery operates at a high voltage such as 4.2 V or above, the dissolution of transition metals in the positive active material intensifies, thereby deteriorating the storage performance and cycle performance of the secondary battery. Through a large number of experiments, the inventor hereof finds that, when the positive active material includes a core and a coating that overlays the surface of the core, and the mass ratio of the coating to the core is 1: (5 to 100), the stability of the secondary battery under high-voltage conditions can be effectively improved, thereby improving the storage performance and cycle performance of the secondary battery. In addition, when the electrolyte solution includes a first solvent selected from fluorinated solvents, the compatibility between the electrolyte solution and the positive and negative electrodes can be improved, thereby further improving the stability of the secondary battery under high-voltage conditions and improving the performance of the secondary battery.

After more in-depth research, the inventor hereof finds that, when the manganese ion dissolution coefficient or the protection layer stability coefficient of the positive electrode plate satisfies specified conditions, the stability of the secondary battery can be further improved significantly, thereby improving the storage performance and cycle performance of the secondary battery.

### [Secondary battery]

A first aspect of this application provides a secondary battery. The secondary battery includes a positive electrode plate, a negative electrode plate, a separator, and an electrolyte solution.

The positive electrode plate includes a positive active material. The positive active material includes a core and a coating. A manganese content of the core is greater than or equal to 25% based on a mass of the core. The coating overlays a surface of the core and contains one or more of an oxide, hydroxide, or oxyacid salt of element X. The element X is one or more selected from Al, B, or P. A mass ratio of the coating to the core is 1: (5 to 100), and optionally 1: (16 to 100).

The electrolyte solution contains a first solvent. The first solvent is one or more selected from a fluorocarbonate ester, a fluorocarboxylate ester, a fluorosulfone, a fluoroether, or a fluorobenzene.

In the secondary battery of this application, the positive active material includes a core and a coating that overlays the surface of the core. The mass ratio of the coating to the core is 1: (5 to 100). The appropriate mass ratio of the coating to the core is conducive to ensuring that the coating effectively reduces the direct contact between the core material and the electrolyte solution, thereby reducing side reactions on the interface and improving the storage performance and cycle performance of the secondary battery. On the other hand, this can also avoid an excessive amount of coating that leads to deterioration of the kinetic performance of the secondary battery. In addition, the coating itself is also a fast-ion conductor, and can avoid significantly reducing the overall capacity of the positive active material, thereby maintaining the high energy density of the secondary battery. In addition, the electrolyte solution in the secondary battery of this application contains the first solvent selected from fluorinated solvents, thereby improving the fluorination degree of the electrolyte solution, improving the compatibility between the electrolyte solution and the positive and negative electrodes, reducing the damage caused by the electrolyte solution to the positive and negative electrode materials, and in turn, improving the storage performance and cycle performance of the secondary battery.

In some embodiments, optionally, a manganese ion dissolution coefficient of the positive electrode plate, denoted as k, satisfies: k ≤ 0.035%, optionally k ≤ 0.017%, and further optionally k ≤ 0.01%, where the manganese ion dissolution coefficient is a mass percent of manganese ions in the electrolyte solution after the positive electrode plate in a fully charged state is stored together with the electrolyte solution at 60 °C for 48 hours, and an injection coefficient of the electrolyte solution is 5 g/Ah).

When the manganese ion dissolution coefficient of the positive electrode plate satisfies the above conditions, this application can significantly improve the stability of the cathode electrolyte interface, reduce side reactions on the interface, improve the stability of the secondary battery, and in turn, improve the storage performance and cycle performance of the secondary battery.

In some embodiments, optionally, a static protection layer stability coefficient of the positive electrode plate is 54% ≤ e1 ≤ 100%, optionally 70% ≤ e1 ≤ 100%, and further optionally 85% ≤ e1 ≤ 100%, where the static protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer when the positive electrode plate is in a fully charged initial state.

The static protection layer stability coefficient e1 can well reflect the extent to which the element X in the positive electrode film layer dissolves into the electrolyte solution. When the static protection layer stability coefficient satisfies the above conditions, the secondary battery is favorably endowed with high stability, thereby improving the storage performance and cycle performance of the secondary battery.

It is hereby noted that after the secondary battery has been used for a period of time, if the mass percent of the element X in the positive electrode film layer in the fully charged initial state of the secondary battery is not known in advance, it is rather difficult to obtain the static protection layer stability coefficient e1. As an alternative, the dynamic protection layer stability coefficient e2 may be used for measuring the rate at which the element X in the positive electrode film layer dissolves into the electrolyte solution. The higher the dynamic protection layer stability coefficient e2, the lower the dissolution rate of the element X in the positive electrode film layer into the electrolyte solution, and the higher the stability of the secondary battery. Conversely, the higher the dissolution rate, the lower the stability of the secondary battery.

In some embodiments, optionally, a dynamic protection layer stability coefficient of the positive electrode plate is 20% ≤ e2 ≤ 100%, optionally 50% ≤ e2 ≤ 100%, and further optionally 70% ≤ e2 ≤ 100%, where the dynamic protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer before the storage.

When the dynamic protection layer stability coefficient e2 falls within the above range, the secondary battery is of relatively high stability, thereby improving the storage performance and cycle performance of the secondary battery.

Generally, the secondary battery includes a positive electrode plate, a negative electrode plate, an electrolyte solution, and a separator. In a charge-and-discharge cycle of the battery, active ions are shuttled between the positive electrode plate and the negative electrode plate by intercalation and deintercalation. The electrolyte solution serves to conduct ions between the positive electrode plate and the negative electrode plate. Disposed between the positive electrode plate and the negative electrode plate, the separator primarily serves to prevent a short circuit between the positive electrode plate and the negative electrode plate while allowing passage of ions. The following describes a positive electrode plate, a negative electrode plate, an electrolyte solution, and a separator of this application.

### [Positive electrode plate]

The positive electrode plate includes a positive current collector and a positive electrode film layer that overlays at least one surface of the positive current collector. The positive electrode film layer includes a positive active material.

As an example, the positive current collector includes two surfaces opposite to each other in a thickness direction of the positive current collector. The positive electrode film layer is disposed on either or both of the two opposite surfaces of the positive current collector.

In some embodiments, the positive current collector may be a metal foil or a composite current collector. For example, the metal foil may be aluminum foil. The composite current collector may include a polymer material substrate and a metal layer formed on at least one surface of the polymer material substrate. The composite current collector may be formed by overlaying the polymer material substrate with a metal material (for example, aluminum, aluminum alloy, nickel, nickel alloy, titanium, titanium alloy, silver, and silver alloy). The polymer material substrate may be, for example, polypropylene (PP), polyethylene terephthalate (PET), polybutylene terephthalate (PBT), polystyrene (PS), or polyethylene (PE).

In some embodiments, optionally, the core in the positive active material of this application is one or more selected from LiMₚMn₂₋ₚO₄, LiN_{q}Mn_{1-q}PO₄, or Li₁₊ₜMn_{1-w}L_{w}O₂₊ₜ, where 0 ≤ p ≤ 1, 0 ≤ q ≤ 0.5, 0 ≤ t ≤ 1, 0 ≤ w ≤ 0.5; and M, N, and L each independently represent one or more of Ni, Co, Fe, Cr, V, Ti, Zr, La, Ce, Rb, P, W, Nb, Mo, Sb, B, Al, or Si.

Further optionally, the core is one or more of LiMₚMn₂₋ₚO₄ or Liⱼ₊ₜMn_{1-w}L_{w}O₂₊ₜ.

Further optionally, the core is one or more of LiNi_{0.5}Mn_{1.5}O₄, LiNi_{0.5}Co_{0.2}Mn_{0.3}O₂, Li₂MnO₃, or LiMnPO₄.

When the core material of the secondary battery is selected from the above types of materials, this application increases the energy density of the secondary battery, reduces the manufacturing cost, and gives rise to little environmental pollution.

In some embodiments, optionally, the coating in the positive active material of this application is one or more selected from aluminum oxide, boron oxide, a borate salt represented by A^{a+}ₓ[BO₃]³⁻_{y}, a phosphate salt represented by A^{a+}ₓ[PO₄]³⁻_{y}, or a aluminate salt represented by A^{a+}ₓ[AlO₂]¹⁻_{z}, in which A represents one or more of Li, Na, K, Rb, Cs, Mg, Ca, Ba, Ni, Fe, Co, Ti, Al, Cr, V, Nb, or W, each compound is electrically neutral, and a, x, y, or z is selected from 1, 2, or 3.

Optionally, the coating is one or more of Al₂O₃, B₂O₃, Li₃BO₃, Li₃PO₄, Na₃PO₄, or LiAlO₂.

When the coating is selected from the above substances, this application reduces the dissolution of transition metals, reduces side reactions on the interface, and in turn, improves battery performance. In addition, the coating itself is also a fast-ion conductor, and can avoid significantly reducing the overall capacity of the positive active material, thereby maintaining the high energy density of the secondary battery.

In some embodiments, optionally, a mass percent of the element X in a positive electrode film layer is 0.05% to 5.35%, optionally 0.1% to 1.61%, and further optionally 0.24% to 1.61%, based on a total mass of the positive active material.

When the mass percent of the element X in the positive electrode film layer falls within the above range, this application can effectively reduce the direct contact between the core material and the electrolyte solution, reduce side reactions, reduce the dissolution of manganese ions, and in turn, improve the storage performance and cycle performance of the secondary battery.

In some embodiments, optionally, the core further includes a doping element. The doping element is one or more selected from W, Nb, Sb, Ti, Zr, La, Ce, or S, and optionally one or more of W or Nb.

Element doping improves the electrochemical properties of the positive active material, thereby enhancing the electrochemical performance of the corresponding secondary battery.

In some embodiments, optionally, the mass percent of the doping element is 0.05% to 5%, and optionally 0.1% to 2%, based on the total mass of the core.

In some embodiments, optionally, particles of the positive active material are monocrystalline or quasi-monocrystalline.

When the positive active material is monocrystalline, the active material is not prone to fragmenting, thereby reducing the probability of exposing a new surface, and in turn, reducing side reactions of the electrolyte solution, and improving the stability of the electrolyte solution.

In some embodiments, optionally, a particle diameter of the positive active material is 1 to 20 µm, and optionally 3 to 15 µm.The particle diameter of the positive active material may be determined by a method commonly used in the art, for example, by referring to the standard GB/T 19077-2016/ISO 13320:2009.

When the particle diameter of the positive active material falls within the above range, this application avoids an increase in the energy consumption of the process and deterioration of the processing performance of the positive electrode plate due to an excessively large particle diameter.

In some embodiments, optionally, the positive active material accounts for 85% to 99%, optionally 93% to 97%, of the total mass of the positive electrode film layer. For example, the positive active material may account for 85%, 90%, 95.5%, or 97% of the total mass of the positive electrode film layer.

In some embodiments, optionally, the positive electrode film layer includes a binder. As an example, the binder may include at least one of polyvinylidene difluoride (PVDF), polytetrafluoroethylene (PTFE), poly(vinylidene fluoride-co-tetrafluoroethylene-co-propylene), poly (vinylidene fluoride-co-hexafluoropropylene-co-tetrafluoroethylene), poly(tetrafluoroethylene-co-hexafluoropropylene), or fluorinated acrylate resin.

In some embodiments, optionally, the binder accounts for 0.1% to 3.5% of the total mass of the positive electrode film layer, and optionally 0.5% to 2.5%.

In some embodiments, the positive electrode film layer further optionally includes a conductive agent. As an example, the conductive agent may include at least one of superconductive carbon, acetylene black, carbon black, Ketjen black, carbon dots, carbon nanotubes, graphene, or carbon nanofibers.

In some embodiments, optionally, the conductive agent accounts for 0.05% to 5%, optionally 0.5% to 3%, of the total mass of the positive electrode film layer.

In some embodiments, the positive electrode plate may be prepared according to the following method: dispersing the ingredients of the positive electrode plate such as the positive active material, the conductive agent, the binder, and any other ingredients into a solvent (such as N-methyl-pyrrolidone) to form a positive electrode slurry, coating a positive current collector with the positive electrode slurry, and performing steps such as drying and cold pressing to obtain the positive electrode plate.

### [Negative electrode plate]

The negative electrode plate includes a negative current collector and a negative electrode film layer disposed on at least one surface of the negative current collector. The negative electrode film layer includes a negative active material.

As an example, the negative current collector includes two surfaces opposite to each other in a thickness direction of the negative current collector. The negative electrode film layer is disposed on either or both of the two opposite surfaces of the negative current collector.

In some embodiments, the negative current collector may be a metal foil or a composite current collector. For example, the metal foil may be copper foil. The composite current collector may include a polymer material substrate and a metal layer formed on at least one surface of the polymer material substrate. The composite current collector may be formed by overlaying the polymer material substrate with a metal material (for example, copper, copper alloy, nickel, nickel alloy, titanium, titanium alloy, silver, and silver alloy). The polymer material substrate may be, for example, polypropylene (PP), polyethylene terephthalate (PET), polybutylene terephthalate (PBT), polystyrene (PS), or polyethylene (PE).

In some embodiments, the negative active material may be a negative active material well-known in the art for use in a battery. As an example, the negative active material may include at least one of the following materials: artificial graphite, natural graphite, soft carbon, hard carbon, silicon-based material, tin-based material, lithium titanium oxide, and the like. The silicon-based material may be at least one selected from elemental silicon, a silicon-oxygen compound, a silicon-carbon composite, a silicon-nitrogen composite, and a silicon alloy. The tin-based material may be at least one selected from elemental tin, a tin-oxygen compound, or a tin alloy. However, this application is not limited to such materials, and other conventional materials usable as a negative active material of a battery may be used instead. One of the negative active materials may be used alone, or at least two thereof may be used in combination.

In some embodiments, the negative electrode film layer further optionally includes a binder. The binder may be at least one selected from styrene-butadiene rubber (SBR), polyacrylic acid (PAA), polyacrylic acid sodium (PAAS), polyacrylamide (PAM), polyvinyl alcohol (PVA), sodium alginate (SA), polymethyl acrylic acid (PMAA), and carboxymethyl chitosan (CMCS).

In some embodiments, the negative electrode film layer further optionally includes a conductive agent. The conductive agent may be at least one selected from superconductive carbon, acetylene black, carbon black, Ketjen black, carbon dots, carbon nanotubes, graphene, or carbon nanofibers.

In some embodiments, the negative electrode film layer further optionally includes other agents, such as a thickener (for example, sodium carboxymethyl cellulose (CMC-Na)).

In some embodiments, the negative electrode plate may be prepared according to the following method: dispersing the ingredients of the negative electrode plate such as the negative active material, the conductive agent, and the binder and any other ingredients in a solvent (such as deionized water) to form a negative electrode slurry, coating a negative current collector with the negative electrode slurry, and performing steps such as drying and cold calendering to obtain the negative electrode plate.

### [Electrolyte solution]

The electrolyte solution serves to conduct ions between the positive electrode plate and the negative electrode plate. Generally, the electrolyte solution includes an electrolyte salt and a solvent.

In some embodiments, optionally, the first solvent in the electrolyte solution of this application is one or more selected from 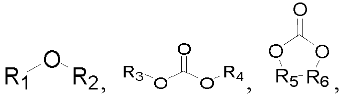 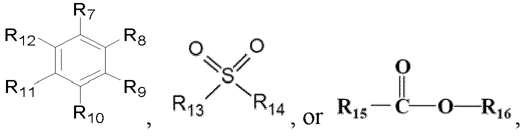 where R₁, R₃, R₅, and R₁₃ each are independently selected from C₁ to C₆ fluoroalkanes; R₂, R₄, R₆, R₁₄, R₁₅, and R₁₆ each are independently selected from C₁ to C₆ alkanes or C₁ to C₆ fluoroalkanes; R₇ to R₁₂ each are independently selected from a C₁ to C₆ fluoroalkane, fluorine, or hydrogen; at least one of R₇ to R₁₂ is selected from fluorine or a fluoroalkane; and at least one of R₁₅ or R₁₆ is selected from C₁ to C₆ fluoroalkanes.

Optionally, the first solvent is one or more of 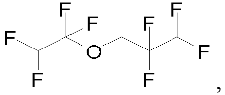 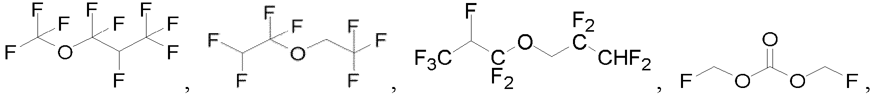 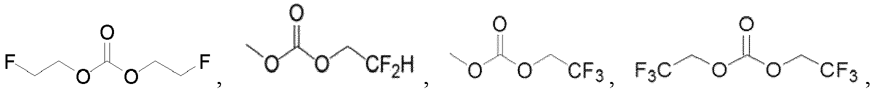 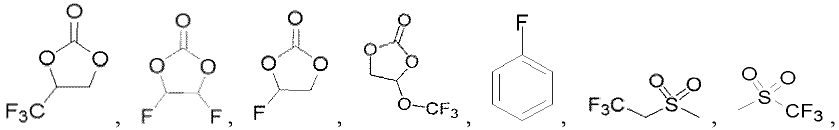 or

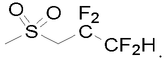

When the electrolyte solution contains the first solvent, the stability of the electrolyte solution is improved, and the compatibility between the electrolyte solution and the positive and negative electrodes is improved, thereby improving the storage performance and cycle performance of the secondary battery.

In some embodiments, optionally, the electrolyte solution further includes a second solvent. The second solvent is one or more selected from a non-fluorinated carbonate ester, a non-fluorinated carboxylate ester, a non-fluorinated ether, or a non-fluorinated sulfone.

Optionally, the second solvent is one or more of 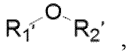 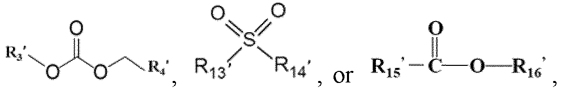 where R₁', R₂', R₃', R₁₃', R₁₄', and R₁₆' each are independently selected from C₁ to C₆ alkanes; and R₄' and R₁₅' each are independently selected from a C₁ to C₆ alkane or hydrogen.

Optionally, the second solvent is one or more of ethyl methyl carbonate, dimethyl carbonate, diethyl carbonate, ethylene carbonate, propylene carbonate, methyl formate, methyl acetate, ethyl acetate, propyl acetate, methyl propionate, ethyl propionate, or propyl propionate.

When both the first solvent and the second solvent are selected from the above solvents, the solvent can combine with a lithium salt in the electrolyte solution to form a special solvation structure, thereby reducing side reactions of the solvent on the surfaces of the positive and negative electrodes and increasing the lifespan of the secondary battery.

In some embodiments, optionally, a mass percent y₁ of the first solvent is 10% to 100%, optionally 40% to 100%, and further optionally 80% to 100%, based on a total mass of the first solvent and the second solvent. As an example, the mass percent y₁ of the first solvent may be 40%, 70%, 80%, 95%, or 100%.

In some embodiments, optionally, a mass percent y₂ of the second solvent is 0% to 90%, optionally 0% to 60%, and further optionally 0% to 20%, based on a total mass of the first solvent and the second solvent. As an example, the mass percent y₂ of the second solvent may be 0%, 5%, 20%, 30%, or 60%.

When the mass percent of the first solvent and the mass percent of the second solvent fall within the above ranges, this application further improves the stability of the electrolyte solution, and improves the storage performance and cycle performance of the secondary battery.

In some embodiments, optionally, the sum of mass of the first solvent and the second solvent is 60% to 90%, and optionally 60% to 87.5%, of the total mass of the electrolyte solution of this application.

When the aggregate mass percent of the first solvent and the second solvent in the electrolyte solution of this application falls within the above range, this application further improves the stability of the electrolyte solution.

In some embodiments, optionally, the mass percent y₁ of the first solvent and a mass percent y₂ of the second solvent satisfy: y₁/y₂ ≥ 0.66, optionally y₁/y₂ ≥ 2.33, and further optionally y₁/y₂ ≥ 4.

When the mass percent y₁ of the first solvent and the mass percent y₂ of the second solvent satisfy the above relation, the electrolyte solution is of higher electrochemical stability, thereby further improving the compatibility between the electrolyte solution and the positive and negative electrodes, reducing side reactions, and improving the storage performance and cycle performance of the secondary battery.

In some embodiments, optionally, the mass percent y₁ of the first solvent and the mass percent y₂ of the second solvent satisfy: 0 <y₁ × y₂/(y₁ + y₂) ≤ 0.25, and optionally 0 ≤ y₁ × y₂/(y₁ + y₂) ≤ 0.16.

When the mass percent y₁ of the first solvent and the mass percent y₂ of the second solvent satisfy the above relation, this application further improves the stability of the electrolyte solution, thereby improving the storage performance and cycle performance of the secondary battery.

In some embodiments, optionally, the electrolyte salt in the electrolyte solution may be at least one selected from lithium hexafluorophosphate, lithium tetrafluoroborate, lithium perchlorate, lithium hexafluoroarsenate, lithium bisfluorosulfonimide, lithium bistrifluoromethanesulfonimide, lithium trifluoromethanesulfonate, lithium difluorophosphate, lithium difluoro(oxalato)borate, lithium bis(oxalato)borate, lithium difluoro(bisoxalato)phosphate, and lithium tetrafluoro(oxalato)phosphate.

In some embodiments, optionally, the concentration of the lithium salt is 5 wt% to 50 wt%, and optionally 8 wt% to 40 wt%, based on the total mass of the electrolyte solution.

When the electrolyte solution includes the lithium salt of the specified concentration, the viscosity of the electrolyte solution is moderate, thereby improving the electron conductivity of the electrolyte solution, and in turn, improving the performance of the secondary battery. However, when the concentration of the electrolyte lithium salt is excessively high, the overall concentration of the electrolyte solution increases, but the dissociation degree of the salt in the electrolyte solution decreases, and the viscosity of the electrolyte solution also increases, which in turn leads to a decrease in the electron conductivity of the electrolyte solution.

In some embodiments, optionally, the electrolyte solution further includes a film-forming additive. The film-forming additive is one or more selected from a chain or cyclic sulfate ester, a chain or cyclic sulfonate ester, a chain or cyclic carbonate ester, a polycyclic sulfate ester, or a polycyclic sulfonate ester.

Optionally, the film-forming additive is one or more of 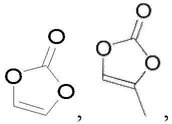 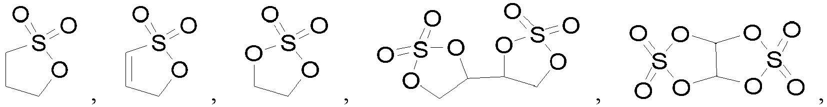 or

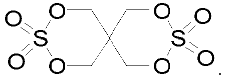

Further optionally, the film-forming additive is one or more of

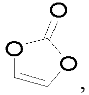

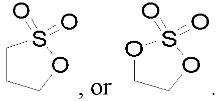

The film-forming additive can form a film on the negative electrode preferentially, thereby reducing the loss of active lithium, and in turn, improving the storage performance and cycle performance of the secondary battery.

In some embodiments, a mass percent of the film-forming additive is 0.5% to 20%, optionally 1% to 10%, and further optionally 1% to 5%, based on a total mass of the first solvent and the second solvent.

In some embodiments, optionally, the film-forming additive includes 0.5% to 3% 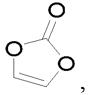 0.5% to 3% 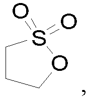 and 0.5% to 3% 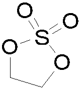 or 0.5% to 3% 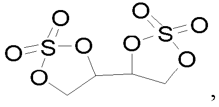 based on a total mass of the first solvent and the second solvent.

When the electrolyte solution includes the film-forming additive added at the specified mass percent, this application further improves the stability of the electrolyte solution, thereby further improving the storage performance and cycle performance of the corresponding secondary battery.

In some embodiments, optionally, the electrolyte solution of this application further includes other functional additives, and the other functional additives may be any additives known in the art that are applicable in the context of this application. As an example, the electrolyte solution further includes at least one of a flame retardant additive, an overcharge protection additive, or a conductive additive. The inclusion of the above additives in the electrolyte solution can further improve the performance of the electrolyte solution.

In some embodiments, optionally, an acidity of the electrolyte solution is less than or equal to 50 ppm, and a purity of each solvent in use is greater than or equal to 99.8%.

When the acidity and purity of the electrolyte solution fall within the above ranges, the electrolyte solution is of high stability and is less prone to side reactions, thereby improving the cycle performance of the secondary battery.

It is hereby noted that the acidity of the electrolyte solution in this application may be determined by a method commonly used in this field. Specifically, with reference to HG/T4067-2015, a triethylamine standard solution may be used to titrate the free acid in the electrolyte solution.

In some embodiments, optionally, the injection coefficient of the electrolyte solution in the secondary battery described in this application is 1.8 to 4 g/Ah, and optionally 2.4 to 3.2 g/Ah. As an example, when the injection coefficient of the secondary battery is 2.8 g/Ah and the battery cell capacity is designed to be 3 Ah, the injection amount is 2.8 × 3 g = 8.4 g.

It is hereby noted that a person skilled in the art understands that the electrolyte solution described in this application may be prepared by a method commonly used by a person skilled in the art. For example, the electrolyte solution described in this application may be prepared by mixing well the first solvent, the second solvent, the lithium salt, the film-forming additive, other additives, and the like at a specified ratio under the protection of an inert gas.

### [Separator]

In some embodiments, the secondary battery further includes a separator. The type of the separator is not particularly limited in this application, and may be any well-known porous separator that is highly stable both chemically and mechanically.

In some embodiments, the separator may be made of a material that is at least one selected from glass fiber, non-woven fabric, polyethylene, polypropylene, and polyvinylidene difluoride. The separator may be a single-layer film or a multilayer composite film, without being particularly limited. When the separator is a multilayer composite film, materials in different layers may be identical or different, without being particularly limited.

A second aspect of this application provides a battery module. The battery module includes the secondary battery according to the first aspect of this application.

A third aspect of this application provides a battery pack. The battery pack includes the battery module according to the second aspect of this application.

A fourth aspect of this application provides an electrical device. The electrical device includes at least one of the secondary battery according to the first aspect, the battery module according to the second aspect, or the battery pack according to the third aspect of this application. The secondary battery, the battery module, or the battery pack may be used as a power supply of the electrical device, or used as an energy storage unit of the electrical device. The electrical device may include, but without being limited to, a mobile device (such as a mobile phone or a laptop computer), an electric vehicle (such as a battery electric vehicle, a hybrid electric vehicle, a plug-in hybrid electric vehicle, an electric bicycle, an electric scooter, an electric golf cart, or an electric truck), an electric train, a ship, a satellite system, or an energy storage system.

The secondary battery, the battery module, or the battery pack may be selected for use in the electrical device according to practical requirements of the electrical device.

Next, a secondary battery, a battery module, a battery pack, and an electrical device according to this application are described below in detail with due reference to drawings.

In some embodiments, the positive electrode plate, the negative electrode plate, and the separator may be made into an electrode assembly by winding or stacking.

In some embodiments, the secondary battery may include an outer package. The outer package may be configured to package the electrode assembly and the electrolyte.

In some embodiments, the outer package of the secondary battery may be a hard shell such as a hard plastic shell, an aluminum shell, a steel shell, or the like. Alternatively, the outer package of the secondary battery may be a soft package such as a pouch-type soft package. The soft package may be made of plastic such as polypropylene, polybutylene terephthalate, or polybutylene succinate.

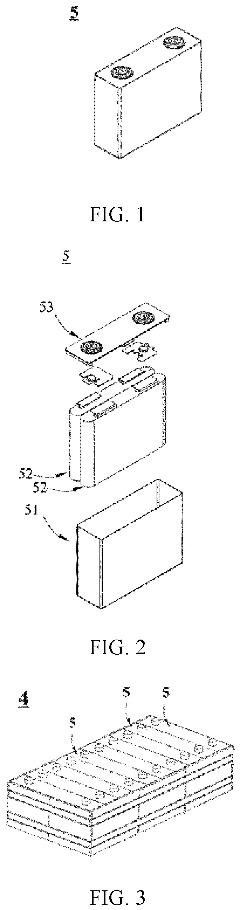

The shape of the secondary battery is not particularly limited in this application, and may be cylindrical, prismatic or any other shape. FIG. 1 shows a prismatic secondary battery 5 as an example.

In some embodiments, referring to FIG. 2, the outer package may include a housing 51 and a cover plate 53. The housing 51 may include a bottom plate and a side plate connected to the bottom plate. The bottom plate and the side plate close in to form an accommodation cavity. An opening that communicates with the accommodation cavity is created on the housing 51. The cover plate 53 can fit and cover the opening to close the accommodation cavity. The positive electrode plate, the negative electrode plate, and the separator may be made into the electrode assembly 52 by winding or stacking. The electrode assembly 52 is packaged in the accommodation cavity. The electrolyte solution infiltrates in the electrode assembly 52. The number of electrode assemblies 52 in a secondary battery 5 may be one or more, and may be selected by a person skilled in the art as actually required.

In some embodiments, the secondary battery may be assembled into a battery module. The battery module may include one or more secondary batteries, and the specific number of secondary batteries in a battery module may be selected by a person skilled in the art depending on practical applications and capacity of the battery module.

FIG. 3 shows a battery module 4 as an example. Referring to FIG. 3, in the battery module 4, a plurality of secondary batteries 5 may be arranged sequentially along a length direction of the battery module 4. Alternatively, the secondary batteries may be arranged in any other manner. Further, the plurality of secondary batteries 5 may be fixed by a fastener.

Optionally, the battery module 4 may further include a shell that provides an accommodation space. The plurality of secondary batteries 5 are accommodated in the accommodation space.

In some embodiments, the battery module may be assembled to form a battery pack. The battery pack may include one or more battery modules, and the specific number of battery modules in a battery pack may be selected by a person skilled in the art depending on practical applications and capacity of the battery pack.

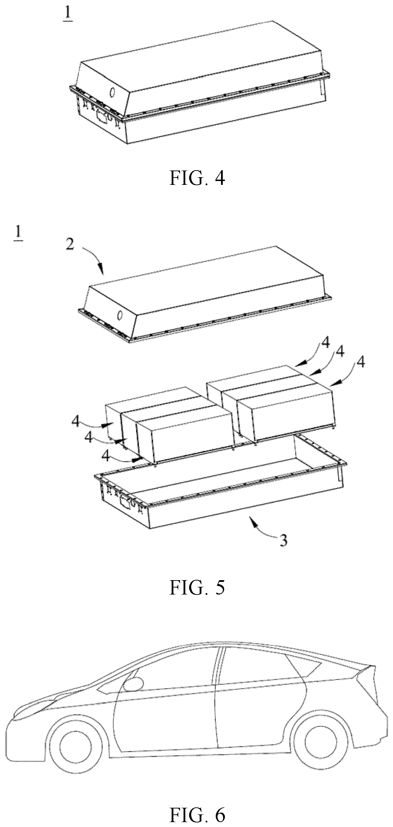

FIG. 4 and FIG. 5 show a battery pack 1 as an example. Referring to FIG. 4 and FIG. 5, the battery pack 1 may include a battery box and a plurality of battery modules 4 disposed in the battery box. The battery box includes an upper box 2 and a lower box 3. The upper box 2 fits the lower box 3 to form a closed space for accommodating the battery modules 4. The plurality of battery modules 4 may be arranged in the battery box in any manner.

FIG. 6 shows an electrical device as an example. The electrical device may be a battery electric vehicle, a hybrid electric vehicle, a plug-in hybrid electric vehicle, or the like. The electrical device may adopt a battery pack or a battery module in order to meet the requirements of the electrical device on a high power and a high energy density of the secondary battery.

In another example, the device may be a mobile phone, a tablet computer, a notebook computer, or the like. The device is generally required to be thin and light, and may have a secondary battery as a power supply.

### Embodiments

The following describes some embodiments of this application. The embodiments described below are illustrative, and are merely intended to construe this application but not to limit this application. Unless techniques or conditions are otherwise expressly specified in an embodiment hereof, the techniques or conditions described in the literature in this field or in an instruction manual of the product are applicable in the embodiment. A reagent or instrument used herein without specifying a manufacturer is a conventional product that is commercially available in the market.

The weight-average molecular weight of the polyvinylidene fluoride (PVDF) used in an embodiment of this application is approximately 900,000, and the purity of various solvents used in an embodiment of this application is greater than 99.9%. It is hereby noted that, unless otherwise expressly specified, the mass of the substances used in an embodiment of this application are measured excluding any water of crystallization.

### Embodiment 1

### Preparing a positive active material

Adding LiNi_{0.5}Mn_{1.5}O₄ into an appropriate amount of deionized water, and stirring well to form a suspension. Subsequently, adding Li₃PO₄ into the suspension, and stirring well. Afterward, performing filtering and drying to obtain a solid powder. Heat-treating the resulting solid powder at 650 °C for 8 hours to obtain LiNi_{0.5}Mn_{1.5}O₄ coated with Li₃PO₄ on the surface. Based on the total mass of the resulting positive active material, the mass percent of the element P in the coating is 0.50%.

The preparation methods of the positive active materials in the comparative embodiments and other embodiments are the same as the above method except the types of the added substances and the content of the corresponding elements.

### Preparing a positive electrode plate

Mixing well the positive active material obtained in the preceding step, carbon black (Super P) as a conductive agent, and polyvinylidene difluoride (PVDF) as a binder at a mass ratio of 95.5: 2.5: 2 in an appropriate amount of NMP solvent to form a uniform positive electrode slurry. Coating both surfaces of a positive current collector aluminum foil with the positive electrode slurry evenly. Performing drying and cold-pressing to obtain a positive electrode plate. The coating concentration of the positive active material on a single side (surface) of the positive current collector is 0.020 g/cm².

### Preparing a negative electrode plate

Mixing well artificial graphite as a negative active material, carbon black (Super P) as a conductive agent, styrene-butadiene rubber as a binder, and sodium carboxymethyl cellulose as a thickener in an appropriate amount of deionized water solvent at a mass ratio of 96: 1: 1: 2 to form a uniform negative electrode slurry. Coating one surface of a negative current collector copper foil with the negative electrode slurry evenly. Performing drying and cold-pressing to obtain a negative electrode plate. The coating concentration of the negative active material on a single side (surface) of the negative current collector is 0.008 g/cm².

### Preparing an electrolyte solution

Mixing various organic solvents well in an argon atmosphere glovebox (H₂O < 0.1 ppm, O₂ < 0.1 ppm) at the mass ratio specified in Table 1, adding the salt and additives shown in Table 1, and stirring well to obtain the electrolyte solution in Embodiment 1.

### Separator

Using a polypropylene film as a separator.

### Preparing a secondary battery

Stacking the positive electrode plate, the separator, and the negative electrode plate in sequence so that the separator is located between the positive electrode plate and the negative electrode plate to serve a function of isolation, so as to form an electrode assembly. Placing the electrode assembly into a battery housing, performing drying and then injecting an electrolyte solution, and performing steps such as chemical formation and standing to obtain a secondary battery disclosed in Embodiment 1. The dimensions of the resulting secondary battery are 60 × 130 × 4 mm, the dimensions of the corresponding positive and negative electrode plates is 87 × 700 mm, and the injection coefficient of the electrolyte solution is 2.8 g/Ah.

### Embodiments 2 to 20 and Comparative Embodiments 1 to 3

Conditions in Embodiments 2 to 20 and Comparative Embodiments 1 to 3 are identical to those in Embodiment 1 except the conditions shown in Table 1.

### Test methods of relevant parameters

### 1. Testing a battery cell capacity (C)

Charging a lithium-ion battery at a constant current of 0.1C at 25 °C until the voltage reaches an upper-limit cut-off voltage, and then charging the battery at a constant voltage equivalent to the upper-limit cut-off voltage until the current is less than 0.05C. Subsequently, discharging the battery at a current of 0.1C until the voltage reaches a lower-limit cut-off voltage, and recording the discharge capacity C (Ah).

### 2. Testing the manganese ion dissolution coefficient and the protection layer stability coefficient

Charging lithium-ion batteries (2 parallel specimens) at a constant current of 0.1C at 25 °C until the voltage reaches an upper-limit cut-off voltage, and then charging the batteries at a constant voltage equivalent to the upper-limit cut-off voltage until the current is less than 0.05C. Subsequently, disassembling the batteries in a glovebox. Soaking the positive electrode plate of one of the lithium batteries in dimethyl carbonate for 1 hour and for 3 times (replacing the dimethyl carbonate for a next soak as soon as one soak is completed), and then drying the positive electrode plate and testing the element content to obtain a mass percent x₁ of the element X in the positive electrode film layer.

Letting the other parallel specimen undergo a similar process, and taking out the positive electrode plate, and then adding the corresponding 5 g/Ah electrolyte solution (with constituents shown in Table 1), performing sealing, and leaving the sealed product to stand in a 60 °C oven for 48 hours. Subsequently, taking out the corresponding electrolyte solution in the glovebox, and then testing the element content to measure the mass percent of manganese ions (manganese element) in the electrolyte solution. Dividing the measured mass percent by the mass of the electrolyte solution to obtain the mass percent y₁ of manganese ions (manganese element) in the electrolyte solution. Correspondingly, soaking the post-storage positive electrode plate in dimethyl carbonate for 1 hour and for 3 times (replacing the dimethyl carbonate for a next soak as soon as one soak is completed), and then drying the positive electrode plate and testing the element content to obtain a mass percent x₂ of the element X in the positive electrode film layer. Therefore, the manganese ion dissolution coefficient of the secondary battery is k = y₁, and the protection layer stability coefficient is e = x₂/x₁.

Both the static protection layer stability coefficient e1 and the dynamic protection layer stability coefficient e2 can be measured by the above method for measuring the protection layer stability coefficient, and the difference is: the secondary battery used for measuring the static protection layer stability coefficient e1 is a freshly prepared secondary battery, but the secondary battery used for measuring the dynamic protection layer stability coefficient e2 may be either a freshly prepared secondary battery or a secondary battery that has been used for a period of time, without being limited. In embodiments and comparative embodiments of this application, the secondary battery for testing is a freshly prepared secondary battery. Therefore, the protection layer stability coefficient in Table 1 is a static protection layer stability coefficient e1.

The manganese ion content in the electrolyte solution and the mass percent of manganese and element X in the positive electrode film layer are determined by inductively coupled plasma (ICP) optical emission spectrometry with reference to the standards EPA6010D-2014 "Inductively Coupled Plasma-Atomic Emission Spectrometry" and JY/T015-1996 "General Rules for Inductively Coupled Plasma-Atomic Emission Spectrometry".

The manganese content and the mass percent of element X (B or P) in the positive electrode film layer may be determined by the following method: punching the positive electrode plate into small discs with a radius of 7 mm, weighing 6 small discs of the positive electrode to obtain a mass m₁, adding 10 ml of aqua regia, heating and fully digesting the mixture, and then adding deionized water until the volume of the solution is 100 ml. Testing the resulting solution by inductively coupled plasma-optical emission spectrometry to obtain the mass percent of the element X contained in the corresponding 6 small discs of the positive electrode, denoted as m₂. In addition, measuring the mass of the substrate (aluminum substrate) of the corresponding 6 small discs with a radius of 7 mm of the positive electrode, denoted as m₃. The mass percent of the corresponding element X is x₁ = m₂/(m₁ - m₃).

When the element X is aluminum, the method for determining the mass percent of the element X in the positive active material is slightly different, and the active material on the surface of the electrode plate needs to be scraped off (but without scraping off the aluminum substrate). The mass of the scraped mixture is measured as m₄. Subsequently, the mass of X in the mixture is measured as m₂ by using the same method as above. Therefore, the mass percent of the corresponding element X (Al) is m₂/m₄.

A specific method for determining the manganese ion content in the electrolyte solution is: taking approximately 1 gram of electrolyte solution, adding 10 ml of concentrated HNO₃ acid (68 wt%), and then heating the mixture at 180 °C for 30 min, and then adding deionized water until the volume of the solution is 50 ml. Testing the solution by inductively coupled plasma-optical emission spectrometry to ultimately obtain the mass of manganese ions (manganese element) in the corresponding electrolyte solution, and dividing the mass of manganese ions by the mass of the electrolyte solution to obtain the mass percent of manganese ions (manganese element) in the electrolyte solution, denoted as y₁.

### 3. Testing the gravimetric capacity of the positive active material

Charging a secondary battery at a constant current of 0.33C at 25 °C until an upper-limit cut-off voltage, and then charging the battery at a constant voltage equivalent to the upper-limit cut-off voltage until the current reaches 0.05C. Leaving the battery to stand for 5 minutes, and then discharging the secondary battery at a constant current of 0.33C until a lower-limit cut-off voltage. The discharge capacity obtained at this time is an initial discharge capacity of the secondary battery.

Initial discharge gravimetric capacity of the positive active material (mAh/g) = initial discharge capacity of the secondary battery/total mass of the positive active material.

### 4. Testing the cycle performance of a secondary battery

Charging a secondary battery at a constant current of 0.1C at 45 °C until an upper-limit cut-off voltage, and then charging the battery at a constant voltage equivalent to the upper-limit cut-off voltage until the current reaches 0.05C. Leaving the battery to stand for 5 minutes, and then discharging the secondary battery at a constant current of 0.1C until a lower-limit cut-off voltage, thereby completing one charge-discharge cycle. The discharge capacity at this cycle is an initial discharge capacity of the secondary battery. Repeating the above method to charge and discharge the secondary battery for a number of cycles until the discharge capacity of the secondary battery fades to 80% of the initial discharge capacity, and recording the number of cycles of the secondary battery at this time. The larger the number of cycles of the secondary battery, the longer the anticipated cycle lifespan of the secondary battery.

### 5. Testing the storage performance of a secondary battery

Charging a secondary battery at a constant current of 0.1C at 25 °C until an upper-limit cut-off voltage, and then charging the battery at a constant voltage equivalent to the upper-limit cut-off voltage until the current drops to 0.05C. At this time, the secondary battery is in a fully charged state. Storing the fully charged secondary battery in a 25 °C environment, taking out the battery every 5 days, and discharging the taken out battery at a constant current of 0.1C until a lower-limit cut-off voltage to obtain a discharge capacity at the end of this storage period, and then charging the secondary battery according to the above charging method until a fully charged state, and then storing the battery back in the 25 °C environment. Repeating the above steps until the discharge capacity of the secondary battery at the end of a storage period fades to 80% of the initial discharge capacity, and then recording the total number of days of storage of the secondary battery. A larger number of days of storage of the secondary battery indicates a longer anticipated lifespan of the secondary battery stored at room temperature.

It is hereby noted that in the embodiments and comparative embodiments in the above performance test, the upper-limit cut-off voltage is 4.95 V, and the lower-limit cut-off voltage is 3.0 V. Table 1 shows the performance test results of Embodiments 1 to 20 and Comparative Embodiments 1 to 3.

**Table 1 Experimental conditions and test results of Embodiments 1 to 20 and Comparative Embodiments 1 to 3 (To be continued)**

| Embodiment | Comparative Embodiment 1 | Comparative Embodiment 2 | Comparative Embodiment 3 | Embodiment 1 | Embodiment 2 |
|---|---|---|---|---|---|
| Coating | | Li₃PO₄ | | Li₃PO₄ | Li₃PO₄ |
| Mass percent of element X (%) | | 0.50 | | 0.50 | 0.1 |
| 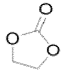 | 30 | 30 | 20 | 20 | 30 |
| 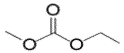 | 70 | 70 | | | 30 |
| 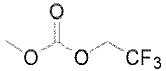 | | | 70 | 70 | 40 |
| 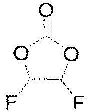 | | | | | |
| 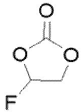 | | | 10 | 10 | |
| 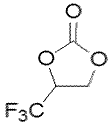 | | | | | |
| 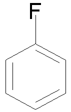 | | | | | |
| 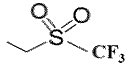 | | | | | |
| 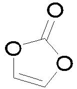 | | | | | |
| 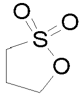 | | | | | |
| 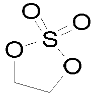 | | | | | |
| Lithium salt/ wt% | LiPF₆/ 12.5% | LiPF₆/ 12.5% | LiPF₆/ 12.5% | LiPF₆/ 12.5% | LiPF₆/ 12.5% |
| Manganese ion dissolution coefficient k (%) | 0.12 | 0.08 | 0.09 | 0.012 | 0.035 |
| Static protection layer stability coefficient e1 (%) | 0 | 23 | 0 | 70 | 54 |
| Gravimetric capacity of positive electrode material | 134.5 | 133.5 | 134.5 | 133.5 | 133.5 |
| Number of cycles at high temperature | 50 | 113 | 102 | 516 | 230 |
| Number of days of storage at room temperature | 55 | 60 | 60 | 195 | 115 |

**Table 1 Experimental conditions and test results of Embodiments 1 to 20 and Comparative Embodiments 1 to 3 (Continued)**

| Embodiment | Embodiment 3 | Embodiment 4 | Embodiment 5 | Embodiment 6 | Embodiment 7 | Embodiment 8 |
|---|---|---|---|---|---|---|
| Coating | Li₃PO₄ | Li₃PO₄ | Li₃PO₄ | Li₃PO₄ | Li₃PO₄ | Li₃PO₄ |
| Mass percent of element X (%) | 0.24 | 0.8 | 0.8 | 0.50 | 0.50 | 0.50 |
| 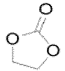 | 30 | 30 | 5 | | | |
| 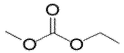 | | | | | | |
| 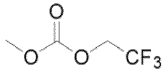 | 70 | 70 | 70 | 70 | 70 | 70 |
| 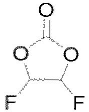 | | | | 15 | | 10 |
| 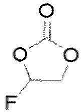 | | | 25 | 15 | 15 | 10 |
| 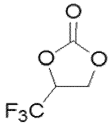 | | | | | 15 | |
| 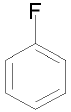 | | | | | | 10 |
| 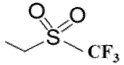 | | | | | | |
| 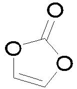 | | | | | | |
| 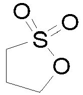 | | | | | | |
| 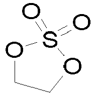 | | | | | | |
| Lithium salt/ | LiPF₆/ | LiPF₆/ | LiPF₆/ | LiPF₆/ | LiPF₆/ | LiPF₆/ |
| wt% | 12.5% | 12.5% | 12.5% | 12.5% | 12.5% | 12.5% |
| Manganese ion dissolution coefficient k (%) | 0.03 | 0.01 | 0.002 | 0.0018 | 0.0018 | 0.0016 |
| Static protection layer stability coefficient e1 (%) | 64 | 85 | 90 | 92 | 92 | 94 |
| Gravimetric capacity of positive electrode material | 133.5 | 128.5 | 128.5 | 133.5 | 133.5 | 133.5 |
| Number of cycles at high temperature | 425 | 513 | 640 | 723 | 736 | 745 |
| Number of days of storage at room temperature | 190 | 235 | 265 | 295 | 295 | 300 |

**Table 1 (Continued)**

| Embodiment | Embodiment 9 | Embodiment 10 | Embodiment 11 | Embodiment 12 | Embodiment 13 | Embodiment 14 |
|---|---|---|---|---|---|---|
| Coating | Li₃PO₄ | Na₃PO₄ | Li₃BO₃ | Al₂O₃ | LiAlO₂ | B₂O₃ |
| Mass percent of element X (%) | 0.50 | 0.50 | 0.50 | 0.50 | 0.50 | 0.50 |
| 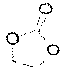 | | 20 | 20 | 20 | 20 | 20 |
| 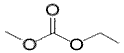 | | | | | | |
| 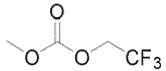 | 70 | 70 | 70 | 70 | 70 | 70 |
| 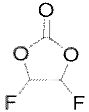 | | | | | | |
| 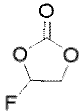 | 10 | 10 | 10 | 10 | 10 | 10 |
| 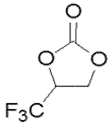 | | | | | | |
| 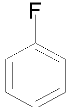 | | | | | | |
| 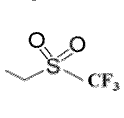 | 30 | | | | | |
| 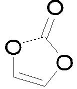 | | | | | | |
| 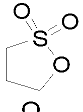 | | | | | | |
| 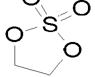 | | | | | | |
| Lithium salt/ wt% | LiPF₆/ 12.5% | LiFSI/ 15% | LiPF₆/ 12.5% | LiPF₆/ 12.5% | LiPF₆/ 12.5% | LiPF₆/ 12.5% |
| Manganese ion dissolution coefficient k (%) | 0.0012 | 0.013 | 0.015 | 0.014 | 0.015 | 0.017 |
| Static protection layer stability coefficient e1 (%) | 95 | 78 | 72 | 74 | 72 | 70 |
| Gravimetric capacity of positive electrode material | 133.5 | 132.5 | 132.5 | 133.5 | 132.5 | 132.5 |
| Number of cycles at high temperature | 766 | 505 | 494 | 522 | 509 | 505 |
| Number of days of storage at room temperature | 305 | 190 | 185 | 200 | 190 | 190 |

**Table 1 (Continued)**

| Embodiment | Embodiment 15 | Embodiment 16 | Embodiment 17 | Embodiment 18 | Embodiment 19 | Embodiment 20 |
|---|---|---|---|---|---|---|
| Coating | Li₃PO₄ | Li₃PO₄ | Li₃PO₄ | Li₃PO₄ | Li₃PO₄ | Li₃PO₄ |
| Mass percent of element X (%) | 0.50 | 0.50 | 0.8 | 1.6 | 5.4 | 6.2 |
| 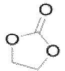 | 20 | 20 | 20 | 20 | 20 | 20 |
| 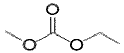 | | | | | | |
| 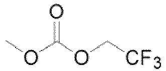 | 70 | 70 | 70 | 70 | 70 | 70 |
| 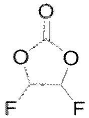 | | | | | | |
| 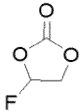 | 10 | 10 | 10 | 10 | 10 | 10 |
| 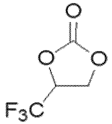 | | | | | | |
| 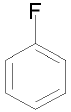 | | | | | | |
| 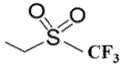 | | | | | | |
| 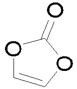 | 1 | 2 | | | | |
| 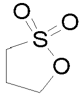 | 1 | 1 | | | | |
| 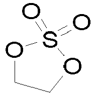 | 1 | | | | | |
| Lithium salt/ wt% | LiPF₆/ 12.5% | LiPF₆/ 12.5% | LiPF₆/ 12.5% | LiPF₆/ 12.5% | LiPF₆/ 12.5% | LiPF₆/ 12.5% |
| Manganese ion dissolution coefficient k (%) | 0.01 | 0.01 | 0.008 | 0.006 | 0.005 | 0.004 |
| Static protection layer stability coefficient e1 (%) | 86 | 86 | 86 | 87 | 88 | 89 |
| Gravimetric capacity of positive electrode material | 133.5 | 133.5 | 132.5 | 124.5 | 113.5 | 99.5 |
| Number of cycles at high temperature | 583 | 566 | 598 | 652 | 733 | 758 |
| Number of days of storage at room temperature | 215 | 210 | 220 | 260 | 290 | 325 |

As can be seen from Table 1, when the positive active material contains the coating and the electrolyte solution contains the first solvent, the storage performance and cycle performance of the corresponding secondary battery are higher than those of the secondary battery containing no coating on the positive active material or containing no first solvent in the electrolyte solution. In addition, when the manganese ion dissolution coefficient k of the positive electrode plate is less than or equal to 0.035% or the static protection layer stability coefficient e1 is greater than or equal to 54%, the storage performance and cycle performance of the corresponding secondary battery are higher. In addition, by adjusting the dosages of the first solvent and the second solvent as well as the type and dosage of the film-forming additive, this application can further improve the storage performance and cycle performance of the secondary battery.

It is hereby noted that this application is not limited to the foregoing embodiments. The foregoing embodiments are merely examples. Any and all embodiments with substantively the same constituents or exerting the same effects as the technical ideas hereof without departing from the scope of the technical solutions of this application still fall within the technical scope of this application. In addition, all kinds of variations of the embodiments conceivable by a person skilled in the art and any other embodiments derived by combining some constituents of the embodiments hereof without departing from the subject-matter of this application still fall within the scope of this application.

## Claims

1. A secondary battery, comprising a positive electrode plate, a negative electrode plate, a separator, and an electrolyte solution, wherein
the positive electrode plate comprises a positive active material, the positive active material comprises a core and a coating, a manganese content of the core is greater than or equal to 25% based on a mass of the core; the coating overlays a surface of the core and contains one or more of an oxide, hydroxide, or oxyacid salt of element X; the element X is one or more selected from Al, B, or P; and a mass ratio of the coating to the core is 1: (5 to 100), and optionally 1: (16 to 100); and
the electrolyte solution contains a first solvent, and the first solvent is one or more selected from a fluorocarbonate ester, a fluorocarboxylate ester, a fluorosulfone, a fluoroether, or a fluorobenzene.

2. The secondary battery according to claim 1, wherein
a manganese ion dissolution coefficient of the positive electrode plate, denoted as k, satisfies: k ≤ 0.035%, optionally k ≤ 0.017%, and further optionally k ≤ 0.01%, wherein the manganese ion dissolution coefficient is a mass percent of manganese ions in the electrolyte solution after the positive electrode plate in a fully charged state is stored together with the electrolyte solution at 60 °C for 48 hours, and an injection coefficient of the electrolyte solution is 5 g/Ah).

3. The secondary battery according to claim 1 or 2, wherein
a static protection layer stability coefficient of the positive electrode plate is 54% ≤ e1 ≤ 100%, optionally 70% ≤ e1 ≤ 100%, and further optionally 85% ≤ e1 ≤ 100%, wherein the static protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer when the positive electrode plate is in a fully charged initial state.

4. The secondary battery according to any one of claims 1 to 3, wherein
a dynamic protection layer stability coefficient e2 of the positive electrode plate satisfies: 20% ≤ e2 ≤ 100%, optionally 50% ≤ e2 ≤ 100%, and further optionally 70% ≤ e2 ≤ 100%, wherein the dynamic protection layer stability coefficient is a ratio of a mass percent of the element X that remains in a positive electrode film layer after the positive electrode plate in a fully charged state is stored together with the electrolyte solution at 60 °C for 48 hours to a mass percent of the element X contained in the positive electrode film layer before the storage.

5. The secondary battery according to any one of claims 1 to 4, wherein
a mass percent of the element X in a positive electrode film layer is 0.05% to 5.35%, optionally 0.1% to 1.61%, and further optionally 0.24% to 1.61%, based on a total mass of the positive active material.

6. The secondary battery according to any one of claims 1 to 5, wherein
the core is one or more selected from LiMₚMn₂₋ₚO₄, LiN_{q}Mn_{1-q}PO₄, or Li₁₊ₜMn_{1-w}L_{w}O₂₊ₜ, wherein 0 ≤ p ≤ 1, 0 ≤ q ≤ 0.5, 0 ≤ t ≤ 1, 0 ≤ w ≤ 0.5; and M, N, and L each independently represent one or more of Ni, Co, Fe, Cr, V, Ti, Zr, La, Ce, Rb, P, W, Nb, Mo, Sb, B, Al, or Si;
further optionally, the core is one or more of LiMₚMn₂₋ₚO₄ or Li₁₊tMn_{1-w}L_{w}O₂₊ₜ; and
further optionally, the core is one or more of LiNi_{0.5}Mn_{1.5}O₄, LiNi_{0.5}Co_{0.2}Mn_{0.3}O₂, Li₂MnO₃, or LiMnPO₄.

7. The secondary battery according to any one of claims 1 to 6, wherein the coating is one or more selected from aluminum oxide, boron oxide, a borate salt represented by A^{a+}ₓ[BO₃]³⁻_{y}, a phosphate salt represented by A^{a+}ₓ[PO₄]³⁻_{y}, or a aluminate salt represented by A^{a+}ₓ[AlO₂]¹⁻_{z}, in which A represents one or more of Li, Na, K, Rb, Cs, Mg, Ca, Ba, Ni, Fe, Co, Ti, Al, Cr, V, Nb, or W, each compound is electrically neutral, and a, x, y, or z is selected from 1, 2, or 3; and
optionally, the coating is one or more of Al₂O₃, B₂O₃, Li₃BO₃, Li₃PO₄, Na₃PO₄, or LiAlO₂.

8. The secondary battery according to any one of claims 1 to 7, wherein
the first solvent is one or more selected from 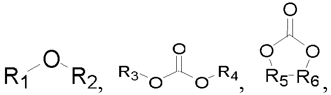 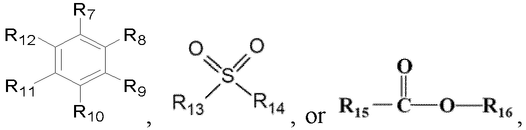 wherein R₁, R₃, R₅, and R₁₃ each are independently selected from C₁ to C₆ fluoroalkanes; R₂, R₄, R₆, R₁₄, R₁₅, and R₁₆ each are independently selected from C₁ to C₆ alkanes or C₁ to C₆ fluoroalkanes; R₇ to R₁₂ each are independently selected from a C₁ to C₆ fluoroalkane, fluorine, or hydrogen; at least one of R₇ to R₁₂ is selected from fluorine or a fluoroalkane; and at least one of R₁₅ or R₁₆ is selected from C₁ to C₆ fluoroalkanes;
optionally, the first solvent is one or more of

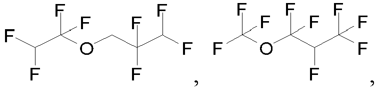

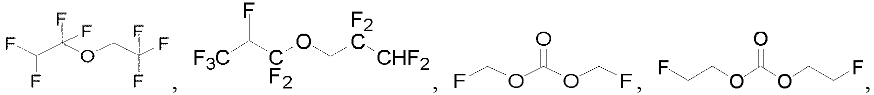

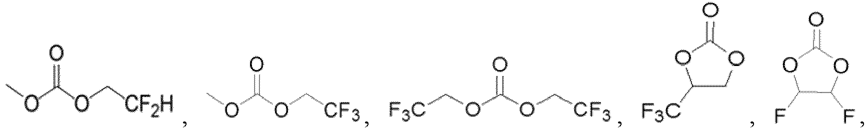

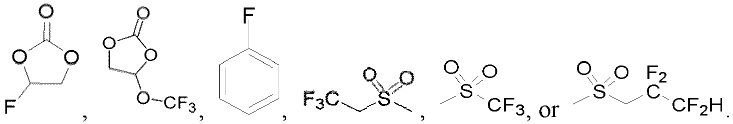

9. The secondary battery according to any one of claims 1 to 8, wherein
the electrolyte solution further comprises a second solvent, and the second solvent is one or more selected from a non-fluorinated carbonate ester, a non-fluorinated carboxylate ester, a non-fluorinated ether, or a non-fluorinated sulfone;
optionally, the second solvent is one or more of 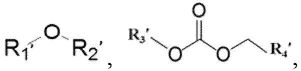 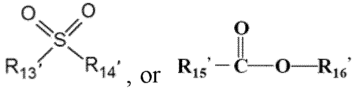 , wherein R₁', R₂', R₃', R₁₃', R₁₄', and R₁₆' each are independently selected from C₁ to C₆ alkanes; and R₄' and R₁₅' each are independently selected from a C₁ to C₆ alkane or hydrogen; and
optionally, the second solvent is one or more of ethyl methyl carbonate, dimethyl carbonate, diethyl carbonate, ethylene carbonate, propylene carbonate, methyl formate, methyl acetate, ethyl acetate, propyl acetate, methyl propionate, ethyl propionate, or propyl propionate.

10. The secondary battery according to claim 9, wherein a mass percent y₁ of the first solvent is 10% to 100%, optionally 40% to 100%, and further optionally 80% to 100%, based on a total mass of the first solvent and the second solvent.

11. The secondary battery according to any one of claims 9 to 10, wherein a mass percent y₂ of the second solvent is 0% to 90%, optionally 0% to 60%, and further optionally 0% to 20%, based on a total mass of the first solvent and the second solvent.

12. The secondary battery according to claim 11, wherein the mass percent y₁ of the first solvent and a mass percent y₂ of the second solvent satisfy: y₁/y₂ ≥ 0.66, optionally y₁/y₂ ≥ 2.33, and further optionally y₁/y₂ ≥ 4.

13. The secondary battery according to any one of claims 1 to 12, wherein
the electrolyte solution further comprises a film-forming additive, and the film-forming additive is one or more selected from a chain or cyclic sulfate ester, a chain or cyclic sulfonate ester, a chain or cyclic carbonate ester, a polycyclic sulfate ester, or a polycyclic sulfonate ester;
optionally, the film-forming additive is one or more of 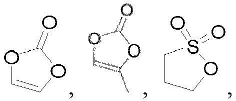 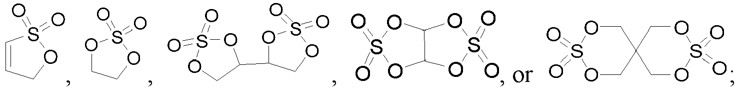 and
further optionally, the film-forming additive is one or more of 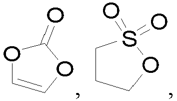 or

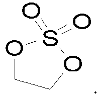

14. The secondary battery according to claim 13, wherein a mass percent of the film-forming additive is 0.5% to 20%, optionally 1% to 10%, and further optionally 1% to 5%, based on a total mass of the first solvent and the second solvent.

15. The secondary battery according to claim 13 or 14, wherein the film-forming additive comprises 0.5% to 3% 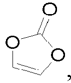 0.5% to 3% 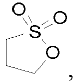 and 0.5% to 3% 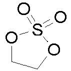 or 0.5% to 3% 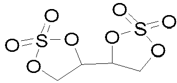 , based on a total mass of the first solvent and the second solvent.

16. The secondary battery according to any one of claims 1 to 15, wherein the core further comprises a doping element, and the doping element is one or more selected from W, Nb, Sb, Ti, Zr, La, Ce, or S, and optionally one or more of W or Nb.

17. The secondary battery according to claim 16, wherein a mass percent of the doping element is 0.05% to 5%, and optionally 0.1% to 2%, based on a total mass of the core.

18. The secondary battery according to any one of claims 1 to 17, wherein particles of the positive active material are monocrystalline or quasi-monocrystalline.

19. The secondary battery according to any one of claims 1 to 18, wherein a particle diameter of the positive active material is 1 to 20 µm, and optionally 3 to 15 µm.

20. The secondary battery according to any one of claims 1 to 19, wherein an acidity of the electrolyte solution is less than or equal to 50 ppm, and a purity of each solvent in use is greater than or equal to 99.9%.

21. A battery module, comprising the secondary battery according to any one of claims 1 to 20.

22. A battery pack, comprising the battery module according to claim 21.

23. An electrical device, comprising at least one of the secondary battery according to any one of claims 1 to 20, the battery module according to claim 21, or the battery pack according to claim 22.
